Europäisches Patentamt

European Patent Office

Office européen des brevets

(11) Publication number: **0 481 637 A2**

# EUROPEAN PATENT APPLICATION

(21) Application number: **91309066.8**

(22) Date of filing: **03.10.91**

(51) Int. Cl.⁵: **C04B 41/90**, C04B 41/88, H01L 21/48

(30) Priority: **16.10.90 US 598518**

(43) Date of publication of application:
**22.04.92 Bulletin 92/17**

(84) Designated Contracting States:
**BE DE FR GB IT NL**

(71) Applicant: **THE BOC GROUP, INC.**
**575 Mountain Avenue**
**Murray Hill New Jersey 07974(US)**

(72) Inventor: **Tamhankar, Satish S**
**2111 Algonquin Drive**
**Scotch Plains, New Jersey 07076(US)**
Inventor: **Kirschner, Mark J**
**38 Mt. Kemble Avenue**
**Morristown, New Jersey 07960(US)**
Inventor: **Marczi, Michael**
**6 Ester Court**
**Old Tappan, New Jersey 07675(US)**
Inventor: **Wolf, Rudoph J**
**11 Hurley Avenue**
**Plainfield, New Jersey 07060(US)**

(74) Representative: **Wickham, Michael et al**
**c/o Patent and Trademark Department The**
**BOC Group plc Chertsey Road**
**Windlesham Surrey GU20 6HJ(GB)**

(54) Method for firing ceramic articles.

(57) In a method for heat processing a ceramic article on which has been printed a conductive or dielectric layer from a photo-imageable paste including an organic binder, an inorganic binder, a plasticiser, a photo-initiation system and a photo-hardenable monomer, after application of radiation to polymerise the monomer, and drying of the layer, the article is subjected to heating first to remove organics, and then to sinter the residual components of the layer. Water vapour is present in the sintering atmosphere in an amount of from about 0.25% to about 2% by volume of the gaseous atmosphere at at least the sintering stage, and preferably at both the binder burn-out stage and the sintering stage. Up to about 10 ppm, and preferably from about 2 ppm to about 3 ppm by volume $H_2$ may be included, the balance of the atmosphere being nitrogen. Conductive ceramic articles heat treated with this atmosphere exhibit a combination of improved properties, including acceptable cohesion of the metallic pattern and adhesion thereof to the ceramic substrate, in combination with improved conductivity.

FIGURE 1

The present invention relates to a method for preparing a ceramic article having a conductor or dielectric circuit element defined thereon by the printing of a thick film paste including a photo-polymerisable monomer, and more particularly to atmospheres used in the firing and sintering of such articles.

Techniques for printing single or plural layer circuit elements on a ceramic substrate construction have evolved rapidly in the semiconductor industry. With increasing sophistication in the development of microcircuitry, the requirements for the manufacture of such circuitry have become far more stringent. Thus, the fabrication of substrate carriers for the mounting of semiconductor chips, ceramic capacitors and entire circuit patterns of micron size necessitates the employment of equally intricate and precise manufacturing methods.

Traditionally, such circuits have been produced by a thick film printing method, wherein a ceramic substrate is printed with one or more coatings or pastes, which are laid down in a predetermined pattern as by screen printing, or the like. In the instance of a circuit having two or more layers, alternate layers of a conductor paste containing a metal conductor material such as copper (or an oxide precursor of such a conductor), and a dielectric paste containing an insulator such as alumina and a silicate glass, may be deposited one on the other, with appropriate connector holes or vias patterned into the dielectric layer.

The formation of the composite article includes a heat treatment, which may comprise the firing of individual layers after their application, or a co-firing of plural layers to form the final circuit. The composite contains overall approximately between 15% and 20% by weight of an organic binder, and is generally prepared with a conductor material that is in the metallic state. Accordingly, the heating schedule and atmosphere are selected to achieve the expeditious removal of the binder component and the sintering of the remaining circuit structure as part of a continuous process. Generally, heating takes place in a belt or other furnace that has a plurality of zones, each zone preprogrammed to proceed at a particular speed and with a particular temperature profile. The heating schedule comprises an initial pre-heat or heat-up where the temperature may range from about 200° to about 500°C. Conventionally, it is during this stage that the binder is removed and the region of the furnace where this operation has been performed has accordingly become known as the binder burn-out region of the furnace.

After pre-heating and binder burn-out are completed, the resulting article is passed to the next stage and region of the furnace where the remainder of the heating process takes place and the firing of the product is completed. This region of the furnace is also known as the hot or sintering zone, and generally employs a neutral (i.e. non-reactive) atmosphere such as nitrogen, to prevent both the oxidation of the metallic conductor and unwanted reduction of the ceramic or glass insulator components from taking place. Temperatures in this region can range up to 900°C or higher.

While such technology was initially developed with conductor pastes including noble metals, the high cost of such metals in conjunction with the substantially expanded need for products of this kind has caused the industry to look to less expensive conductor metals such as copper for use in their place. While copper represents a low cost alternative offering desirable conductivity and other electric properties in the final product, it is more sensitive to oxidation, and firing atmospheres must be more carefully controlled. In this connection, reference is made to US-A-4,474,731 and US-4,504,339 for representative approaches to the adjustment of heating conditions, be they atmospheric or other, to optimise binder removal. In this latter connection, US-A-4,504,339 suggests the use of a quantity of moisture or water vapour during binder burn-out to optimise binder removal.

As discussed earlier, the modulation of atmospheres is critical, as it is undesirable to convert ceramic and glass components of the paste to their elemental states. For example, US-A-4,504,339 specifically caution against including water vapour in its sintering atmosphere as moisture is perceived to be an oxidising influence. Moreover, Yext et al. ("A Study of Various Nitrogen-Based Furnace Atmospheres and Their Effects on Copper Thick-Film Conductors and Dielectrics," Proceedings of the 1985 International Symposium on Microelectronics, ISHM, 583-591) note that the presence of moisture appeared to inhibit the adhesion of the copper film to the ceramic substrate. Thus, the traditional approach to the performance of the final sintering step wherein the copper paste and film are finally bonded to the substrate, has proceeded in an essentially neutral atmosphere, such as nitrogen.

A review of the prior art with respect to the firing of ceramic conductor articles of this general type is set forth in US-A-4,891,246 and the disclosure of this patent is accordingly incorporated herein by reference for that purpose.

EP-A-0 308 851 provides an alternative approach to the heating of copper thick-film conductors, as it suggests the use of a furnace heated by an infrared or near-infrared radiation source utilising an atmosphere to which water is added, to yield improved properties in the resulting fired ceramic conductor. This disclosure, however, is qualified on page 3 thereof, where it is indicated that the use of moisture or water vapour in a conventionally heated furnace produces inferior copper thick-films. Thus, while offering a solution to the problem, EP-A-0 308 851 teaches that the use of water vapour is limited to infrared or near-infrared furnaces and is inoperable in conventional furnaces.

Moreover, the process according to EP-A-0 308 851 is for the removal of organic components, and accordingly, is primarily concerned with the atmosphere present at the binder burn-out step and the effect of the modulation of that atmosphere on the properties of the finally fired product, rather than with the inclusion of water vapour at any other stage in the heating process. Indeed, EP-A-0 308 851 offers no insight into the unique problems that are faced in the instance of pastes of a kind including a photo-polymerisable monomer where involved binder vehicles, photo-initiators and other diverse ingredients are present which must be fully removed for a coherent and commercially acceptable product to be formed.

Indeed, the selection of processing parameters becomes further complicated in the instance of such photo-imageable pastes. The advantages of using photo-imageable materials are apparent, as, for example, cylindrical shaped vias as small as 100 $\mu$m and fine conductor lines with widths of 25 $\mu$m are possible. This is achieved by the use of conventional thick film processing except that after deposition of the conductive pattern, further exposure of the coated substrate to ultraviolet light followed by washing of the coated substrate with a suitable solvent, can further remove portions of the copper paste to define the desired pattern.

Photo-imageable pastes have binder systems include appropriate photo-hardenable monomer and a photo-initiation system including photo-active organic compounds which also possess desired rheological properties. Such organic compounds are generally more difficult to remove compared to those used in alternative commercial products, and in the instance of certain aqueous photopolymer systems tend to require increased oxidative activity of the system to effectively remove the binder. The result has been that binder burn-out must be more stringently performed, as the potential for unwanted oxidation of the metallic conductor material is increased. This processing stringency adds further difficulty to the subsequent heat treatment of the metal pattern, and reduced dielectric properties, undesirable loss of adhesion and in many instances, total failure of the final product are experienced.

In view of the above, a need exists for the development of a heat treating procedure for photo-imageable compositions that can effectively remove the organic binder and other organic materials while at the same time facilitating the preparation of a commercially suitable electronic product possessing desired cohesion, improved conductivity and adhesion of the conductive pattern to the ceramic substrate.

According to the invention there is provided a method of heat treating an article comprising a ceramic substrate having printed thereon (to form a component or components of an electrical circuit) including a volatilisable organic and a conductive metal or dielectric material, said method comprising (after subjecting the composition to radiation) the steps of:

a) heating the article to remove completely the organic binder and the other organic materials; and

b) further heating said article in an atmosphere, including from 0.25 to 2% by volume of water vapour, to sinter the residual components of the coating composition.

The method according to the invention may be used when the article additionally has printed thereon a layer of coating composition including a ceramic dielectric material, said layer including a ceramic dielectric material being interposed between layers of photo-imageable coating composition including a conductive metal. The layer including a ceramic dielectric material is itself desirably of a photo-imageable coating composition. Typically, each layer is subjected to radiation to cause polymerisation of monomer therein, and then to treatment to remove any unwanted part of the deposited layer, and is then dried and subjected to steps (a) and (b) above before the next layer is printed. The sintering atmosphere preferably comprises from about 0.25% to about 1.5%, more preferably from about 0.25% to about 1.2%, and most preferably about 1% by volume of $H_2O$, the balance being non-oxidising component such as nitrogen. In a preferred embodiment, the atmosphere for the sintering step comprises water vapour in the amounts stated, together with up to about 10 ppm, and preferably from about 2 to about 3 ppm by volume of $H_2$, and the balance being essentially $N_2$.

The present method is particularly effective for the processing of ceramic circuits prepared from photo-imageable pastes, and in particular those pastes having an aqueous-based component therein, as the method resolves certain of the difficulties that have been encountered with conventional heat processing. Thus, plural layered articles prepared in accordance with the invention exhibit a combination of cohesion, improved conductivity and dielectric properties such as hermeticity, and improved adhesion of the copper or other conductive metal pattern to its substrate. The added moisture unexpectedly serves herein to enhance integrity of the resulting article as it assists in the consolidation of the ceramic and copper components of this paste composition as firing progresses.

The present method likewise achieves an economy of processing, as, for example, the temperature for the sintering step in the instance of difficulty volatilisable binders may be lowered by as much as 50/C while

4

accomplishing the improved consolidation and corresponding increase in adhesion of the conductor metal to the ceramic substrate. Also, the processing time is reduced by almost 50% in the present instance.

The present method is preferably performed on a continuous basis. The present method contemplates the residence of the coated ceramic article in a belt furnace, for example, with curtains disposed between the various sections of the furnace where changes in the heating atmosphere would be made. The heating atmosphere may utilise a primary component of moist nitrogen.

The atmosphere for the present method could be provided by various methods, including the bubbling of nitrogen through water, or by the generation of moisture with a catalytic humidifier. A representative catalytic humidifier is disclosed in US. Patent No. 3,630,956 to Benning et al., the disclosure of which is incorporated herein by reference. Other comparable gas generating means may be used.

The invention shall now be described by way of example with reference to the accompanying drawings, in which:

FIGURE 1 is a scanning electron micrograph of the surface of a copper coated ceramic article prepared from a photo-imageable conductor paste, which has been fired under an essentially non-oxidising prior art sintering atmosphere distinguishable by the absence of water vapour.

FIGURE 2 is a scanning electron micrograph of the surface of a copper coated ceramic conductor prepared identically to that shown in Figure 1, with the exception that the sintering atmosphere contains a quantity of water vapour in accordance with the present invention.

As mentioned earlier, the processing of photo-imageable (or photo-formable) coating compositions carries with it additional stringency as binder burn-out is made more difficult because of the nature and diversity of the ingredients of the photo-imageable material.

In the method according to the invention, there is fabricated a ceramic article by the selective printing on a ceramic substrate of a predetermined conductor or dielectric from a photo-imageable paste or composition pattern. A photo-imageable paste or coating composition includes an inorganic glass-containing composition to serve as an inorganic binder, an organic polymeric binder, a volatile plasticiser, a photo-initiation system including appropriate initiator compounds and a photo-hardenable monomer. If the circuit element to be printed is a conductor, then the photo-imageable coating composition additionally includes a chosen conductive metal. If the circuit element to be printed is a dielectric then the photo-imageable coating composition includes a suitable dielectric. By subjecting the printed pattern to radiation of an appropriately short wave length (e.g. UV radiation) the polymerisation of the monomer is initiated. Representative photo-imageable compositions are disclosed in US-A-4,598,037, US-A-4,908,296 and EP-A-0 357 063 all of which disclosures are incorporated herein by reference and made a part hereof.

While the ingredients of such compositions and their importance in the operation of the coating composition are adequately set forth in the patents referenced above, and it can be seen that the very use of these compositions carries with it complexity and process criticality. The organic binder system serves to hold the composition in place after printing, but is capable of removal by an appropriate solvent which in certain instances may be water, after the selective application of appropriate photo-polymerising radiation. The ingredients of certain photo-polymerisable compositions appear to require additional oxidation for binder burn-out, and this is believed to add difficulty to heat treatment of ceramic substrates coated with such photo-imageable conductor compositions with conventional furnace atmospheres to form coherent conductors with acceptable electrical characteristics.

To prepare a ceramic substrate, which may be in the green state or already fired, such substrate is coated with a photo-imageable conductor-containing composition, followed by the selective application of appropriate radiation to define the specific circuit pattern desired. The product thus treated is thereafter rinsed in a suitable solvent to remove unwanted portions of the coating, and the resulting product is now ready for final processing in accordance with the present invention.

The present invention provides striking results over heat treatments employing conventional heating atmospheres to which moisture or water vapour has not been added. Specifically, essentially non-oxidising sintering atmospheres that have been successfully employed with conventional copper conductor pastes have failed when the conductor paste is of a photo-imageable composition. Particularly when the system employs one or more aqueous-based components therein, the formation of a coherent sintered metal pattern has been found to be impossible. Moreover, the as-fired ceramic circuits exhibit unacceptably low adhesion of the copper to the ceramic substrate. Therefore, the method according to the present invention does not merely improve the properties of the finally fired ceramic article bearing an electrical circuit but represents the first instance where acceptable products of this kind have been prepared with the particular paste compositions set forth herein.

While not wishing to be bound to a particular theory of operation, it is believed that the moisture or water vapour included in the sintering phase of the present heat treatment serves to modify the tetrahedral silica structure of the glass phase that is present in the paste formulation as a sintering aid. This is believed to lead to a reduced viscosity of the glass phase and consequently hastens consolidation of the conductor particles at a lower temperature level. As noted earlier, the sintering of the photo-imageable conductor paste compositions within the atmosphere of the present invention, may be achieved under less stringent temperature conditions than has been previously possible with certain photo-polymerisable conductor pastes. For example, the maximum sintering temperature in the hot zone for a particular paste has been lowered by a temperature of at least 50°C from that employed prior hereto.

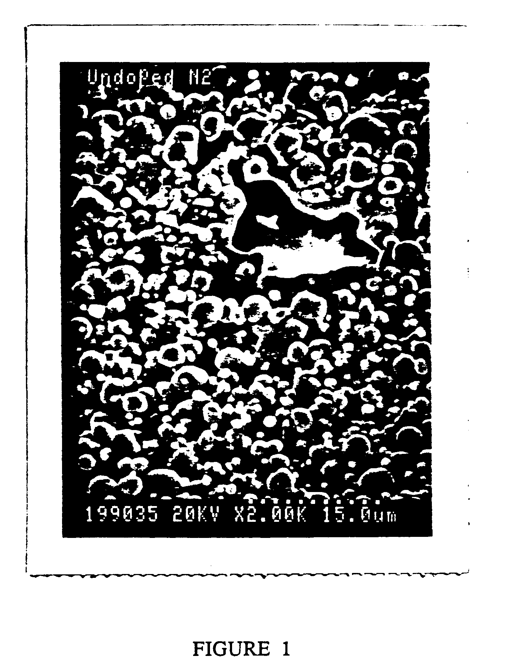

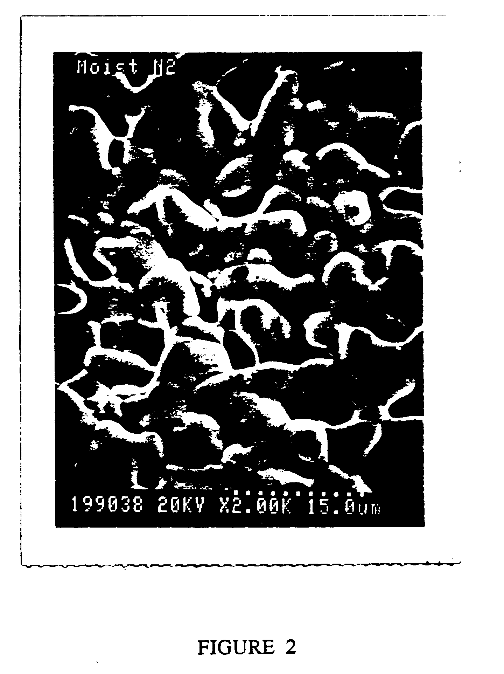

A copper film formed in accordance with the present invention exhibits an adhesion strength that is higher than that for a film processed in conventional fashion with oxygen doping during binder burn-out. For example, while conventional processing results in an adhesion strength of 1.76 kg/pad, the present method yields an adhesion strength of 2.2 kg/pad. Further evidence of the improved properties and particularly the uniformity and cohesion of conductor products prepared in accordance with the present invention, is evident from a comparative review of Figures 1 and 2 herein. The figures represent photographs from scanning electron microscopic examination of the surfaces of as-fired samples of ceramic circuit articles with copper conductor patterns prepared from a photo-imageable copper conductor paste representative of the present invention. Both samples were prepared and processed identically, with the exception that one of the samples was sintered in a firing atmosphere containing 1% water vapour. Other parameters were maintained constant.

Referring first to Figure 1, the surface of the sample shown in Figure 1 does not appear well sintered and, although some sintered grains are observed, the majority of the microstructure consists of spherical particles. Dot mapping of the sample was performed in regions where large "bright" chunks of material were found, and the chunks in question were determined to be glass-rich, suggesting that numerous discontinuities in the copper surface representing glassy inclusions owing to incomplete consolidation on firing are present. This is consistent with the results that have been obtained in the instance where the copper conductor paste contains a photo-imageable binder system and firing is conducted under the conventional non-oxidising sintering atmosphere.

By contrast, Figure 2 depicts properly sintered and coherent copper. The grain structure of the copper conductor appears uniform and suggests thorough sintering and coherence favourably comparable with commercially acceptable sintered copper conductor materials. Apparently, the addition of moisture in the amount indicated resulted in the formation of a fully coherent and acceptable copper conductor surface as fired.

In addition to the visual and mechanical attributes that are attained by the method of the present invention, copper conductors prepared by this method exhibit improved electrical properties. For example, resistivity measurements were made of the conductors depicted in Figures 1 and 2. The average resistivity of the conductor sample fired in an atmosphere of undoped nitrogen and depicted in Figure 1 was 22.5 m ohm square, while that of the inventive conductor sample as depicted in Figure 2 was 3.25 m ohm square. As a lower resistivity value reflects a corresponding improvement in conductivity, the sharply lower value exhibited by the inventive sample clearly demonstrates its superiority and the corresponding improvement in performance attainable by the present invention over the prior art.

As mentioned earlier, the essential aspect of the invention comprises the introduction of water vapour into the non-oxidising sintering atmosphere. Moisture or water vapour may likewise be introduced into the burn-out atmosphere in accordance with a further embodiment of the invention, wherein it will serve in part to improve binder burn-out while at the same time reducing or eliminating extrinsic oxygen requirements as well as facilitating the transition from the binder burn-out step to the sintering step. The amount of water vapour that may be introduced at the binder burn-out step may vary in accordance with the ranges set forth above with respect to the sintering step. Accordingly, moisture or water vapour may be added to the burn-out atmosphere in an amount by volume ranging from about 0.25% to about 2%, preferably from about 0.25% to about 1.5%, more preferably from about 0.25% to about 1.2%, and most preferably at or about 1%, all by volume. The employment of moisture in both the burn-out and sintering steps of the present method facilitates the use of a single atmosphere throughout heat treatment and confers a consequent economy and efficiency of processing.

The heating atmosphere of the invention may be supplemented during sintering by the inclusion of up to about 10 ppm hydrogen and preferably, from about 2 to about 3 ppm hydrogen. The addition of hydrogen is optional, as certain of the photo-imageable binder pastes are more reactive and, as a result, yield copper coatings that tend to exhibit some delamination.

The method according to the invention may also be used in firing dielectric or insulating layers printed from photo-imageable compositions. The dielectric properties of the insulator or dielectric layers of a multilayer circuit prepared in this manner are determined by the measurement and analysis of certain parameters and, in particular, dielectric constant (K), dielectric loss factor (tan δ), insulation resistance and breakdown voltage (BV). For a particular layer to act as an insulator, it is desirable that the layer exhibit a low dielectric constant and dielectric loss factor with good hermeticity as indicated by low leakage current, high insulation resistance and high breakdown voltage. Frequently, processing conditions result in favourable ratings in certain categories which are, however, wanting in other categories. In this context, the present method achieves products having a combination of favourable characteristics.

The present invention will be better understood from a review of the following illustrative examples comparing the inventive process with those of the prior art, and wherein all percents expressed are percent by volume unless otherwise indicated. The examples illustrate the printing of a dielectric layer from a photo-imageable composition.

## EXAMPLE 1

In this example, samples prepared with thick film pastes utilising a photo-imageable binder composition subjected to test firing to compare the present test firing method with that developed by the proprietor of the paste, E. I. Dupont de Nemours & Co. In particular, the Dupont firing procedure involves the addition to the burn-out zone of a quantity of $O_2$ to assist in binder removal, followed by a nitrogen-based sintering atmosphere. The procedures for the preparation and firing of the samples and the results of the tests are set forth below.

## EXPERIMENTAL PROCEDURES

### Sample Preparation

The materials used in this experiment were: Dupont 9924 copper conductor paste (of conventional kind) and a developmental photo-imageable dielectric thick film paste system compatible with copper conductors. Samples were prepared first by screen printing and drying, and were thereafter fired. Printing and drying was performed in a class 100 clean hood using Coors 2" x 2", 96% alumina substrates. After printing, the samples were allowed to settle for 5-7 minutes and were dried in a conveyorised infrared oven. For each layer, a print/dry/fire sequence was followed, and between the steps samples were stored in a nitrogen-purged box until further processing or testing was performed. The printing parameters were adjusted to obtain a fire thickness of about 10 μm for the conductor and about 50 μm total for the dielectric layer.

Samples were fired in a Lindberg 6" belt furnace. Provisions were made for introducing controlled quantities of dopant gases to various locations in the furnace muffle. Desired dopant levels were monitored and maintained by sampling at different locations along the muffle and by making appropriate adjustments. Analysers used for monitoring the furnace atmosphere included an electrochemical oxygen analyser, a chilled-mirror dew point analyser, and a gas chromatograph for the analysis of other gas species.

### Test Methods

Tests were performed thoroughly to characterise the dielectric properties of the material fired under different atmosphere. The measurements included dielectric constant, loss factor, insulation resistance, breakdown voltage and leakage current.

The leakage current, LC, was measured using an electrolytic cell, with the copper on a test specimen as one electrode and a platinum foil as the other, both immersed approximately 1" apart in a 1 N NaCl solution. The leakage current was measured by applying 10 volts potential between the two electrodes. Solderability of the exposed copper conductor was determined by measuring the coverage area and the weight gain after a standard solder dipping technique using 63Pb/37Sn solder and Alpha 611 flux.

The dielectric constant K and the loss factor tan / were measured using a Hewlett Packard model 4192A LCR meter. All capacitance measurements were performed at 10 KHz frequency under ambient conditions. The dielectric constant was calculated using the formula,

$$K = (0.95\ CT)/(EA)$$

where

C =      measured capacitance (Farads);
T =      dielectric thickness (inches)
E =      permittivity of free space,

2.249 x $10^{-1}$ Picofarads/inch;

A =      surface area of the capacitor plate;

0.95 =      correlation factor for edge effects.

The DC breakdown voltages were measured using an Associated Research model 4045 Hi-pot tester. Test leads were attached to the ground plane and the area designated BV on the test pattern. The sample was then submerged in a silicone oil to contain the arcing at breakdown. The voltage was allowed to increase at approximately 100 volts/second, until breakdown occurred. Insulation resistance was measured using a Hewlett Packard Model 4329A high resistance meter, with 50 volts DC applied between the ground plane and the top conductor pads. The data derived from this test are tabulated and set forth in Table 1, below.

TABLE 1

| Property | Control* | Inventive** |
|---|---|---|
| Dielectric constant | 7.5 | 5.65 |
| Insulation resistance (ohm) | 1 x $10^{12}$ | 7.3 x $10^3$ |
| Breakdown voltage (volts/mil) | 750 - 850 | 880 |
| Leakage current*** ($\mu A/cm^2$) | 20 | 38 |

\* Processed in $N_2$ and $O_2$ in the burn-out zone.

\*\* Processed in $N_2$ + 1.3 - 1.5 vol% $H_2O$ in the burn-out zone.

\*\*\* Failure criterion: > 125 $\mu A/cm^2$

From a review of the above results, the dielectric constant, insulation resistance and breakdown voltage of the samples processed in accordance with the invention showed improvement by the use of the present processing atmosphere in the burn-out region. The results illustrate that the atmosphere of the present invention can significantly influence the properties of the photo-imageable dielectric materials used in the test.

EXAMPLE 2

Based upon the results achieved in the initial experiments set forth in Example 1 above, a more extensive test program was undertaken to explore the role of various dopants in modifying material properties. Accordingly, and as set forth in Table 2, a variety of dopants including moisture, carbon dioxide and $N_2O$ as well as undoped nitrogen, were tested and compared. The various dielectric parameters were then tested as indicated in Example 1 above, and the results tabulated as set forth in Table 2, below.

8

**TABLE 2**

| Atmosphere | Dielectric constant K | % CV | tan δ | % CV | Breakdown voltage (V/mil) | %CV | Leakage current ($\mu A/cm^2$) | %CV |
|---|---|---|---|---|---|---|---|---|
| undoped $N_2$ | 6.81 | 2.5 | 0.041 | 17 | 783 | 10 | large | – |
| $O_2$* | 7.5 | – | – | – | 800 | – | 20 | – |
| 100 ppm $O_2$ in burn-out | 7.82 | 6.2 | 0.0016 | 9 | 2025 | 6 | 7 | 50 |
| 5000 ppm $N_2O$ in burn-out | 8.14 | 12.6 | 0.0014 | 19 | >2500 | – | 11 | 40 |
| 2% $CO_2$ in burn-out | 5.2 | 4.2 | 0.059 | 12 | 821 | 13 | large | – |
| 2% $CO_2$ throughout | 5.05 | 6.8 | 0.071 | 22 | 813 | 21 | 2022 | 9 |
| 1.3% $H_2O$** in burn-out | 5.65 | 3.0 | – | – | 880 | 24 | 38 | 40 |
| 1% $H_2O$** throughout | 5.26 | 4.27 | 0.0028 | 7 | 1971 | 6 | 28 | 44 |
| 0.5% $H_2O$*** throughout | 6.56 | 5.32 | 0.0025 | 6 | 1546 | 12 | 400 | 20 |
| 1% $H_2O$*** | 7.7 | – | 0.0012 | – | 1500 | – | 8 | – |

CV = Coefficient of Variation
* oxygen doping procedure
** moisture produced through catalytic humidifier
*** moisture produced through bubbler

From a review of Table 2, it can be seen that while the additions of oxygen currently utilised with the photo-imageable compositions of particular interest herein, improved dielectric hermeticity as reflected by high BV values and low LC values, the dielectric constant (K) actually increases under these conditions. Likewise, $CO_2$ doping results in the lowest dielectric constant, but the dielectric loss factor (tan δ) is higher and the leakage current is too large. Of the atmospheres employed, water vapour appears to provide the best overall results and thereby confirms that the atmosphere of the present invention offers a full spectrum of desired dielectric properties in ceramic circuits treated in accordance therewith. It is to be appreciated that comparable advantages arise when the photo-imageable paste includes a copper conductor.

This invention may be embodied in other forms or carried out in other ways without departing from the spirit or essential characteristics thereof. The present disclosure is therefore to be considered as in all respects illustrative and not restrictive, the scope of the invention being indicated by the appended Claims, and all changes which come within the meaning and range of equivalency are intended to be embraced therein.

**Claims**

1. A method of heat treating an article comprising a ceramic substrate having printed thereon (to form a component or components of an electrical circuit) at least one layer of a photo-imageable coating composition including a volatilisable organic binder and a conductive metal, said method comprising (after subjecting the composition to radiation) the steps of:
    a. heating the article to remove completely the organic binder and other organic materials; and
    b. further heating said article in an atmosphere to sinter the residual components of the coating composition;
    characterised in that the sintering atmosphere includes from 0.25 to 2% by volume of water vapour.

2. A method according to Claim 1, in which the article additionally has printed thereon a layer of coating composition including a ceramic dielectric material, said layer being interposed between layers of said photo-imageable coating composition.

3. A method according to Claim 2, in which the coating composition including the ceramic dielectric material is itself photo-imageable.

4. A method according to Claim 2 or Claim 3, in which each layer is subjected to steps (a) and (b) before any subsequently layer is printed.

5. A method according to Claim 3 or Claim 4, in which the as-fired article exhibits freedom from carbonaceous impurities, improved adhesion of conductor metal to the substrate, improved cohesion and electrical conductivity of the conductive metal, and improved dielectric properties of the dielectric material.

6. A method of heating treating an article comprising a ceramic substrate having printed thereon (to form a component or components of an electrical circuit) a layer of photo-imageable coating composition including a volatilisable organic binder and a dielectric material, said method comprising (after subjecting the composition to radiation) the steps of:
    a) heating the article to remove completely the organic binder and other organic materials; and
    b) further heating said article in an atmosphere to sinter the residual components of the coating composition;
    characterised in that the sintering atmosphere includes from 0.25 to 2% by volume of water vapour.

7. A method according to any one of the preceding claims, in which the sintering atmosphere is non-oxidising.

8. A method according to any one of the preceding claims, in which the sintering atmosphere contains from 0.25 to 1.2% by volume of $H_2O$.

9. A method according to claim 8, in which the sintering atmosphere contains 1% by volume of $H_2O$.

10. A method according to any one of the preceding claims, in which up to 10 ppm by volume of hydrogen is added to the sintering atmosphere.

11. A method according to Claim 10, in which the sintering atmosphere has added to it from 2 to 3 ppm by volume of hydrogen.

12. A method according to any one of the preceding claims, in which the balance of the sintering atmosphere consists essentially of nitrogen.

13. A method according to any one of the preceding claims, in which the or each photo-imageable composition include at least one component that is water based.

**14.** A method according to any one of claims 1 to 5, in which the conductor is copper.

**15.** An article when made by a method as claimed in any one of the preceding claims.

FIGURE 1

FIGURE 2